# EUROPÄISCHE PATENTSCHRIFT

(11) **EP 2 577 738 B1**
(45) Veröffentlichungstag und Bekanntmachung des Hinweises auf die Patenterteilung: **17.01.2018**
(21) Anmeldenummer: 11724960.7
(22) Anmeldetag: 30.05.2011
(51) Int. Cl.: H01L 31/0465, H01L 31/05

(54) **DÜNNSCHICHTSOLARMODUL UND HERSTELLUNGSVERFAHREN HIERFÜR**
THIN FILM SOLAR MODULE AND METHOD FOR PRODUCING SAME
MODULE SOLAIRE À COUCHE MINCE ET SON PROCÉDÉ DE FABRICATION

(30) Priorität: 02.06.2010 DE 102010017223
(43) Veröffentlichungstag der Anmeldung: 10.04.2013
(73) Patentinhaber: Calyxo GmbH, 06766 Bitterfeld-Wolfen (DE)
(72) Erfinder: FRITSCHE, Jochen, 06780 Zörbig, OT Salzfurtkapelle (DE); BECKER, Frank, 04105 Leipzig (DE); HUCHEL, Matthias, 39359 Calvörde (DE); BAUER, Michael, 04129 Leipzig (DE)
(74) Vertreter: Hecht, Jan-David
(86) Internationale Anmeldenummer: PCT/EP2011/002660
(87) Internationale Veröffentlichungsnummer: WO 2011/151048

(56) Entgegenhaltungen:
- EP-A2- 2 043 154
- WO-A2-03/050891
- DE-A1-102006 057 454
- JP-A- 7 297 436
- US-A- 4 315 096
- US-A1- 2002 092 558
- US-A1- 2009 260 671

## Beschreibung

Die Erfindung betrifft ein Dünnschichtsolarmodul und ein Herstellungsverfahren für ein Dünnschichtsolarmodul.

Dünnschichtsolarmodule sind in der Regel aus einer Vielzahl einzelner Solarzellen aufgebaut, welche miteinander serienverschaltet sind. Deshalb entspricht der Gesamtstrom des Moduls dem Strom aus einer einzelnen Solarzelle, während sich die Leerlaufspannungen der einzelnen Solarzellen in der Serienschaltung im Wesentlichen addieren. Um eine möglichst hohe Ausgangsleistung zu erzielen, müssen die Solarzellen schmal ausgebildet sein, weil dann Verluste aufgrund geringer Flächenleitfähigkeiten der Kontaktschichten und Serienwiderstände minimiert werden. Ein Beispiel für ein derartiges Dünnschichtsolarmodul ist in JP2001-111083A offenbart. Darin werden einzelne Submodule aus serienverschalteten Solarzellen beschrieben, wobei die Submodule wiederum untereinander in Serie verschaltet sind.

Werden jedoch sehr viele Solarzellen in Reihe geschaltet, was bei Aufteilung des Moduls in viele schmale Solarzellen der Fall ist, erzeugt das Modul eine sehr hohe Spannung und einen sehr niedrigen Strom. Hohe Spannungen sind allerdings für die Verwendung solcher Dünnschichtsolarmodule in Photovoltaik-Anlagen ungeeignet und machen diese unwirtschaftlich. Bei einem derart einfachen Dünnschichtsolarmodul ist also ein Kompromiss zwischen Solarzellenbreite und Modulspannung zu wählen, wodurch aber in der Regel nicht die Ernte des vollen Leistungspotentials der Solarzellen ermöglicht werden kann.

Zur Verringerung der Modulspannung des Solarmoduls werden deshalb gleichartige Teilmodule aus serienverschalteten Solarzellen zueinander parallel verschaltet. Für jedes Teilmodul sind hierbei zwei Sammelleiter oder Zellkontaktbänder notwendig, jeweils ein Zellkontaktband zur Kontaktierung der ersten (positiv) und der letzten (negativ) in einer Reihe serienverschalteter Solarzellen. Alle positiven und negativen Zellkontaktbänder werden dann zu einem Modulaußenanschluss zusammengefasst, an dem die erzeugte Leistung von Außen abgegriffen wird.

In US 2009/0260671 wird ein Dünnschichtsolarmodul mit mehreren Teilmodulen beschrieben, welche untereinander parallel verschalteten sind. Die Parallelverschaltung erfolgt hierbei über eine gemeinsame, photovoltaisch inaktive Solarzelle. Eine photovoltaisch inaktive Solarzelle in jedem Teilmodul führt jedoch insgesamt zu einer geringeren Lichtausbeute für das Dünnschichtsolarmodul.

Einen ähnlichen Weg verfolgt US 2008/0142070 A1. Das darin beschriebene Dünnschichtsolarmodul ist ebenfalls aus Teilmodulen zusammengesetzt, welche über gemeinsame Solarzellen an den Teilmodulenden beziehungsweise Teilmodulrändern parallelverschaltet sind. Gegenüber US 2009/0260671 ist hier zwar die Anzahl an inaktiven Solarzellen reduziert. Die gemeinsamen Solarzellen, welche aktiv sind, unterscheiden sich jedoch von den übrigen Solarzellen. Sie müssen daher an den übrigen Solarzellen angepasst werden, um mit ihnen serienverschaltet werden zu können, was zusätzliche Arbeitsschritte erfordert. Ebenfalls über gemeinsame, sich von den übrigen Solarzellen unterscheidende Solarzellen parallelverschaltete Teilmodule, umfasst das in JP2005-353767A offenbarte Solarzellenmodul.

Demgegenüber wird in JP2000-049369A ein aus mehreren Teilmodulen zusammengesetztes Dünnschichtsolarmodul beschrieben, bei dem die Teilmodule über Randsolarzellen miteinander in alternierender Polarisation verschaltet sind. Die Verschaltung der Teilmodule erfolgt hierbei über gemeinsame Busbars, welche in die Schichten des Dünnschichtsolarmoduls hinein bis zur Vorderseitenelektrode hineinreichen. Dies erfordert einen zusätzlichen Verfahrensschritt zur Ausbildung der Busbars. Zudem wird wertvolle Solarmoduloberfläche zwischen den Teilmodulen für die Busbars vergeudet, welche dann nicht mehr für die aktive Halbleiterschicht zur Verfügung steht.

Aus DE 101 09 643 A1, JP 2004-327 901 A, JP 2003 152 211 A und JP 07 297 436 A sind Solarzellenmodule bekannt, bei denen in einem ersten Schritt Submodule durch Brechen von einander getrennt und diese Submodule dann in einem nachfolgenden Schritt auf einem gemeinsamen Substrat zur Herstellung des Solarzellenmoduls aufgebracht werden.

Aus US 4,315,096 ist ein Solarzellenmodul bekannt, bei dem die Submodule nicht voneinander durch Brechen getrennt werden, sondern durch einen Strukturierungsprozess monolithisch hergestellt werden. Die US 5,593,901 A und JP 61 073 386 A zeigen ebenfalls monolithisch aufgebaute Dünnschichtsolarmodule.

Es ist Aufgabe der Erfindung, ein Dünnschichtsolarmodul und ein Herstellungsverfahren zu seiner Herstellung bereitzustellen, so dass auf kostengünstige Weise die Flächenausbeute und die Effizienz des Dünnschichtsolarmoduls erhöht werden.

Die Aufgabe wird gemäß der Erfindung durch ein Dünnschichtsolarmodul mit den Merkmalen des Anspruchs 1 und ein Herstellungsverfahren mit den Merkmalen des Anspruchs 11 gelöst. Vorteilhafte Weiterbildungen der Erfindung sind in den Unteransprüchen aufgeführt.

Die Erfindung beruht auf dem wesentlichen Merkmal, dass die Parallelverschaltung der beiden benachbarten Teilmodule nicht über eine den Teilmodulen gemeinsame Solarzelle erfolgt, sondern über jeweils am Rand eines jeweiligen Teilmoduls angeordnete Verbindungszellen. Hierbei ist zu beachten, dass sich die Verbindungszellen vorteilhafterweise von den übrigen Solarzellen innerhalb der Teilmodule nicht Wesentlich unterscheiden.

Während der Gemeinschaftskontakt eine Kontaktierung zwischen der ersten und der zweiten Verbindungszelle bildet, sind die Verbindungszellen ansonsten mittels des Isoliergrabens voneinander beabstandet und isoliert. Der Gemeinschaftskontakt, welcher die beiden Verbindungszellen kontaktiert, ist vorzugsweise Teil einer Rückseitenkontaktschicht, kann jedoch auch unter Umständen Teil einer Vorderseitenkontaktschicht sein. Als Teil einer ohnehin für die Herstellung der Dünnschichtsolarzelle verwendeten Kontaktschicht ist die Bildung des Gemeinschaftskontakts ohne zusätzliche Verfahrensschritte möglich.

Bei der Herstellung des Dünnschichtsolarmoduls ist es vorteilhaft, zunächst auf einem Substrat nacheinander eine Vorderseitenkontaktschicht, eine Halbleiterschicht und eine Rückseitenkontaktschicht aufzubringen, beispielsweise mittels Abscheidung. Das Substrat und die Vorderseitenkontaktschicht müssen hierbei hinreichend transparent sein, um beim Einsatz des Solarmoduls einfallendes Licht durchzulassen. Hierzu kann als Substrat Fensterglas und als Vorderseitenkontaktschicht ein transparentes leitfähiges Oxid verwendet werden. Die genannten Schichten werden während oder nach dem Aufbringen derart strukturiert, dass sie eine Reihe von serienverschalteten Solarzellen bilden, welche gruppenweise, nämlich in Teilmodulen zusammengefasst, parallelverschaltet sind. Zumindest zwei der Teilmodule werden hierbei über oben genannte Verbindungssolarzellen mittels eines Gemeinschaftskontakts miteinander elektrisch verbunden. Zur Trennung der beiden Verbindungszellen mittels des Isoliergrabens erstreckt sich der Isoliergraben vorzugsweise zumindest über eine Halbleiterschichtdicke einer Halbleiterschicht. Bei einer bevorzugten Ausführungsform ist vorgesehen, dass sich der Isoliergraben zumindest im Wesentlichen vollständig über eine Halbleiterschichtdicke einer Halbleiterschicht und zudem über eine Kontaktschichtdicke einer Vorderseitenkontaktschicht erstreckt. Dies kann dadurch erreicht werden, dass nach dem Aufbringen der Vorderseitenkontaktschicht und der Halbleiterschicht, diese beiden Schichten gleichzeitig strukturiert werden, indem Isoliergräben durch die beiden Schichten hindurch erzeugt werden. Die Isolierschichten reichen also bis zu dem Substrat.

In einer vorteilhaften Weiterbildung ist vorgesehen, dass der Isoliergraben teilweise oder vollständig mit einem Isoliermaterial gefüllt ist. Zum einen kann mittels Auswahl eines geeigneten Isoliermaterials die Isoliereigenschaft des Isoliergrabens verbessert werden. Zudem verhindert beispielsweise eine vollständige Auffüllung des Isoliergrabens ein Eindringen von weiterem Abscheidungsmaterial beim Abscheiden weiterer Schichten nach dem Bilden des Isoliergrabens, insbesondere bei der Abscheidung einer Rückseitenkontaktschicht. Als Isoliermaterial kann ein Kunststoff oder ein Lack verwendet werden.

Gemäß einer zweckmäßigen Ausgestaltung ist vorgesehen, dass die erste Verbindungszelle und / oder die zweite Verbindungszelle photovoltaisch aktiv ist. Die Vermeidung von photovoltaisch inaktiven Solarzellen in dem Dünnschichtsolarmodul führt zu einer Erhöhung des Wirkungsgrades.

Bevorzugterweise ist vorgesehen, dass der Isoliergraben entlang einer Spiegelfläche verläuft, bezüglich derer das erste Teilmodul und das zweite Teilmodul zueinander im Wesentlichen spiegelbildlich ausgebildet sind. Die spiegelbildliche Ausgestaltung der beiden Teilmodule bezüglich der Spiegelfläche bedingt, dass die Teilmodule im Verhältnis zueinander in entgegengesetzte Richtungen polarisiert sind. Dieses Merkmal der entgegengesetzten Polarisation kann auch ohne eine streng spiegelbildliche Ausgestaltung erreicht werden und bedingt, dass die in den Teilbereichen erzeugten Ströme in Gegenrichtung zueinander fließen, also entweder zu der Spiegelfläche oder von ihr weg.

Bei einer vorteilhaften Ausführungsform sind weitere Teilmodule vorgesehen, wobei die Teilmodule entlang einer parallel zu einer Solarmoduloberfläche verlaufenden Querrichtung alternierend polarisiert sind. Hierbei ist es zweckmäßig, dass zumindest zwei Teilmodule über eine photovoltaisch inaktive Brückensolarzelle miteinander parallelverschaltet sind. Die Brückensolarzelle kann hierbei dadurch photovoltaisch inaktiv geworden sein, dass ihre Halbleiterschicht mittels mit leitfähigem Material gefüllten Kontaktgräben beidseitig kurzgeschlossen ist.

Folglich kann eine Ausführungsform konkret so aussehen, dass in Querrichtung betrachtet benachbarte Teilmodule abwechselnd über zwei aktive Verbindungszellen und über eine inaktive Brückenzelle paarweise miteinander verschaltet sind.

Gemäß einer bevorzugten Weiterbildung ist vorgesehen, dass die Solarzellen streifenförmig sind und sich der Isoliergraben im Wesentlichen entlang einer gesamten Länge der angrenzenden Verbindungszellen erstreckt. In dieser Ausführungsform würde die oben genannte Querrichtung quer oder im Wesentlichen senkrecht zu der Längsrichtung verlaufen, entlang der sich die streifenförmigen Solarzellen erstrecken.

Um die derart miteinander parallelverschalteten Teilmodule von außen zugänglich zu machen, werden auf der Solarmoduloberfläche Längssammelleiter und Quersammelleiter angeordnet, welche letztlich mit einem Modulaußenanschluss verbunden sind. Anders ausgedrückt, können die Teilmodule aus serienverschalteten streifenförmigen Solarzellen mittels Sammelleiter miteinander und mit dem Modulaußenanschluss verbunden sein, um von dort die in dem Dünnschichtsolarmodul mittels Umwandlung einfallenden Lichts erzeugte elektrische Leistung abzugreifen. Hierzu sind vorteilhafterweise sich entlang einer Erstreckungsrichtung der streifenförmigen Solarzellen erstreckende Längssammelleiter vorgesehen, von denen einer auf dem Gemeinschaftskontakt angeordnet und mit diesem elektrisch verbunden ist. Ferner sind zwei quer zu den Längssammelleitern verlaufende und diese kontaktierende Quersammelleiter vorgesehen.

Während die nachfolgend beschriebene Verschaltung des Dünnschichtsolarmoduls mittels Längssammelleiter und Quersammelleiter für die hier beschriebenen Dünnschichtsolarmodule mit über einem Gemeinschaftskontakt verbundene Verbindungszellen besonders angepasst ist, kann sie auch für anders strukturierte Dünnschichtsolarmodule vorteilhaft eingesetzt werden, um die darin erzeugte elektrische Leistung effizient abgreifen zu können.

Kontaktpunkte zwischen den Längssammelleitern und Quersammelleitern können hierbei mittels Lötverbindungen, Schweißstellen, beispielsweise Ultraschallschweißstellen (sogenannten utrasonic bonds oder US bonds), Klebeverbindungen oder dergleichen gebildet sein. Dies gilt auch für Kontaktpunkte zwischen den Längssammelleitern oder Quersammelleitern und der Rückseitenkontaktschicht der Solarzellen. Die Kontaktpunkte befinden sich an Kreuzungspunkten zwischen Längssammelleitern und Quersammelleitern.

Gemäß einer bevorzugten Ausgestaltung ist vorgesehen, dass zwischen den Längssammelleitern und den Quersammelleitern Isolierstreifen derart angeordnet sind, dass mittels der Längssammelleiter und der Quersammelleiter die Parallelverschaltung der Teilmodule hergestellt ist. Mittels der Isolierstreifen wird ein elektrischer Kontakt zwischen Längssammelleiter und Quersammelleiter an jenen Kreuzungspunkten verhindert, an denen Kontaktpunkte nicht vorgesehen sind.

Bevorzugterweise ist vorgesehen, dass zwischen den Quersammelleitern und einer Rückseitenkontaktschicht des Dünnschichtsolarmoduls zumindest ein Isolierband angeordnet ist. Das Isolierband dient hierbei zur elektrischen Trennung der Quersammelleiter gegenüber den Solarzellen und / oder gegenüber den Längssammelleitern an Stellen, an denen ein Kontakt nicht erwünscht ist. Wenn ein einziges Isolierband verwendet wird, sollte dieses zumindest eine Breite aufweisen, welche einer doppelten Quersammelleiterbreite der Quersammelleiter entspricht oder übersteigt, sodass beide Quersammelleiter gleichzeitig darauf Platz finden. Es können jedoch auch zwei oder mehr Isolierbänder eingesetzt werden.

Isolierband und / oder Isolierstreifen können aus flächigem Isoliermaterial geschnitten sein. Vorzugsweise weisen das Isolierband und / oder die Isolierstreifen zur einfachen Handhabung einseitig oder beidseitig Haftmittel auf. In den Ausführungsformen, in denen sowohl ein oder mehrere Isolierbänder als auch Isolierstreifen vorgesehen sind, können beide Isolierungsmittel aus dem gleichen Material gebildet sein.

In einer zweckmäßigen Weiterbildung ist vorgesehen, dass die Längssammelleiter entlang der Querrichtung alternierend auf einem Gemeinschaftskontakt und auf einem Kontakt einer Brückensolarzelle angeordnet und damit elektrisch verbunden sind. Anders ausgedrückt, ist jeder zweite Längssammelleiter auf einem Gemeinschaftskontakt aufgebracht. Um die Parallelverschaltung der Teilmodule zu bewerkstelligen, sind die auf den Gemeinschaftskontakten angeordneten Längssammelleiter mit einem der Quersammelleiter und die auf den Kontakten der Brückensolarzellen angeordneten Längssammelleiter mit dem anderen der Quersammelleiter elektrisch verbunden. Eine hiervon abweichende Verschaltung ist jedoch möglich, indem eines der Quersammelleiter oder beide nach dem Aufbringen auf das Dünnschichtsolarmodul durchtrennt werden.

Für die Verschaltung des Dünnschichtsolarmoduls mittels Sammelleiter werden ein Isolierband, mehrere Längssammelleiter und zumindest zwei Quersammelleiter nacheinander auf die Solarmoduloberfläche aufgebracht, wobei die Reihenfolge des Aufbringens dieser Elemente von der jeweiligen Ausführungsform abhängt. In jedem Fall werden die Quersammelleiter auf die Solarmoduloberfläche quer zu einer Erstreckungsrichtung der Längssammelleiter aufgebracht, wobei das Aufbringen des Isolierbandes, der Längssammelleiter und der Quersammelleiter derart erfolgt, dass mittels der Längssammelleiter und der Quersammelleiter die Parallelverschaltung der Teilmodule hergestellt wird.

Gemäß einer vorteilhaften Ausführungsform wird das Isolierband nach dem Aufbringen der Längssammelleiter und vor dem Aufbringen der Quersammelleiter auf die Solarmoduloberfläche aufgebracht, wobei vor, während oder nach dem Aufbringen des Isolierbandes Öffnungen in das Isolierband zur Kontaktierung der Längssammelleiter mit den Quersammelleitern erzeugt werden. Die Reihenfolge in diesem Fall lautet also: Erst die Längssammelleiter, dann das Isolierband oder die Isolierbänder, und schließlich die Quersammelleiter. In dieser Ausführungsform sind keine zusätzlichen Isolierstreifen mehr notwendig, da die elektrische Isolierung der Quersammelleiter gegenüber den Längssammelleitern bereits mittels des Isolierbandes erreicht wird.

In einer alternativen Ausgestaltung des Herstellungsverfahrens ist vorgesehen, dass die Längssammelleiter auf das Isolierband aufgebracht werden, wobei nach dem Aufbringen der Längssammelleiter und vor dem Aufbringen der Quersammelleiter Isolierstreifen an Kreuzungspunkten zwischen den Längssammelleitern und den Quersammelleitern angeordnet werden. Hier lautet die Aufbringungsreihenfolge ausgehend von der Solarmoduloberfläche also: Erst das Isolierband oder mehrere Isolierbänder, dann die Längssammelleiter, dann die Isolierstreifen und schließlich die Quersammelleiter.

Gemäß einer weiter abgewandelten Ausgestaltung des Herstellungsverfahrens ist vorgesehen, dass die Längssammelleiter auf das Isolierband aufgebracht werden, wobei vor dem Aufbringen der Längssammelleiter und nach dem Aufbringen der Quersammelleiter Isolierstreifen an Kreuzungspunkten zwischen den Längssammelleitern und den Quersammelleitern angeordnet werden. In diesem Fall lautet also die Reihendfolge wie folgt: Erst das Isolierband oder mehrere Isolierbänder, dann die Quersammelleiter, dann die Isolierstreifen und schließlich die Längssammelleiter. Gegenüber der vorangehend genannten Ausführungsform wird somit hierbei die Reihenfolge des Aufbringens von Quersammelleiter und Längssammelleiter vertauscht.

In einer zweckmäßigen Ausführungsform wird eines der Quersammelleiter mit beiden Polen eines Modulaußenanschlusses elektrisch verbunden, wobei der Quersammelleiter vor oder nach dem Verbinden mit den Polen des Modulaußenanschlusses durchtrennt wird, um die beiden Pole voneinander elektrisch zu isolieren. Dies hat den erheblichen Vorteil, dass außer den genannten beiden Quersammelleitern keine weiteren Sammelleiter für die Kontaktierung der Längssammelleiter notwendig sind.

Die Erfindung wird im Folgenden anhand von Ausführungsbeispielen unter Bezugnahme auf die Figuren erläutert. Hierbei zeigen:
- Fig. 1: eine schematische Querschnittansicht eines Solarmoduls gemäß Stand der Technik;
- Fig. 2: schematisch die Stromverläufe in dem Solarmodul aus der Fig. 1;
- Fig. 3: eine schematische Querschnittansicht eines Dünnschichtsolarmoduls mit zwei über zwei Verbindungszellen verbundenen Teilmodulen;
- Fig. 4: schematisch die Stromverläufe in dem Solarmodul aus der Fig. 3;
- Fig. 5: eine Querschnittansicht eines Dünnschichtsolarmoduls mit vier Teilmodulen;
- Fig. 6: eine Querschnittansicht eines Dünnschichtsolarmoduls mit vier Teilmodulen gemäß einer zu Fig. 5 alternativen Ausführungsform;
- Fig. 7: eine schematische Abbildung eines mittels Sammelleitern verschalteten Dünnschichtsolarmoduls in Draufsicht;
- Fig. 8: ein Schaltplan zur Erläuterung der Verschaltung des Dünnschichtsolarmoduls gemäß der Fig. 8; und
- Fig. 9: eine Abbildung eines mit Längssammelleitern versehenen Dünnschichtsolarmoduls in Draufsicht mit einem alternativen Isolierband, vor dem Aufbringen von Quersammelleitern.

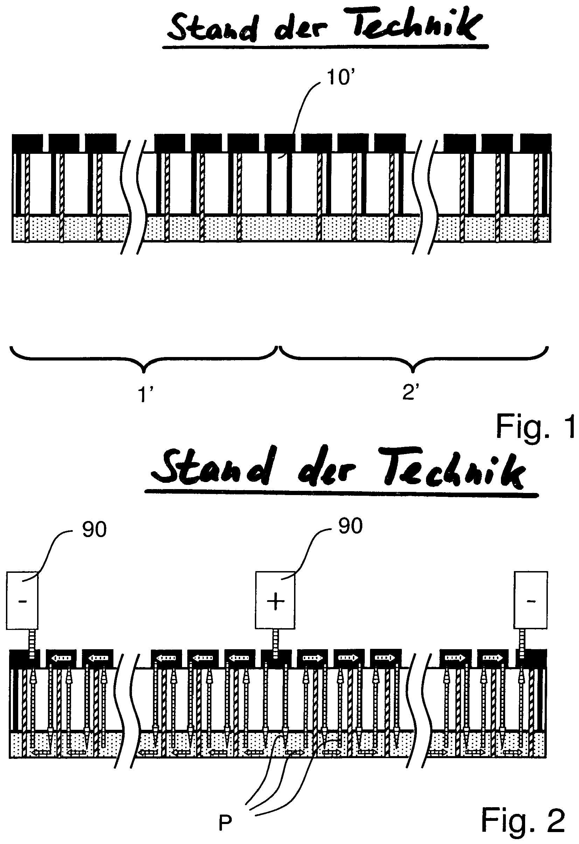

Anhand der Fig. 1 und 2 werden nachfolgend Solarmodule gemäß dem Stand der Technik aus US 2009/0260671 erläutert. Die Fig. 1 zeigt schematisch eine Querschnittansicht eines bekannten Solarmoduls mit streifenförmigen Solarzellen, wobei die Schnittfläche quer zu einer Längsrichtung der Solarzellenstreifen verläuft. Das Solarmodul umfasst zwei Teilmodule 1', 2', welche über eine gemeinsame, photovoltaisch inaktive Solarzelle 10' miteinander verbunden sind.

In der Fig. 2 wird anhand von Stromflusspfeilen P der Stromfluss innerhalb des bekannten Solarmoduls veranschaulicht. Hierzu ist das Solarmodul schematisch über Abgreifkontakte 90 elektrisch kontaktiert dargestellt, wobei die den beiden Teilmodulen 1', 2' gemeinsame Solarzelle 10' an einem positiven Abgreifkontakt 90 angeschlossen ist. Da die gemeinsame Solarzelle 10' photovoltaisch inaktiv ist, fließt der Strom beim Betrieb des Solarmoduls von dem positiven Abgreifkontakt 90 aus über zwei die gemeinsame Solarzelle 10' flankierende Leitungsbereiche in die beiden Teilmodule 1', 2'. Aufgrund des symmetrischen Aufbaus der Teilmodule ausgehend von der gemeinsamen Solarzelle 10', ist auch der in Fig. 2 dargestellte Stromfluss symmetrisch.

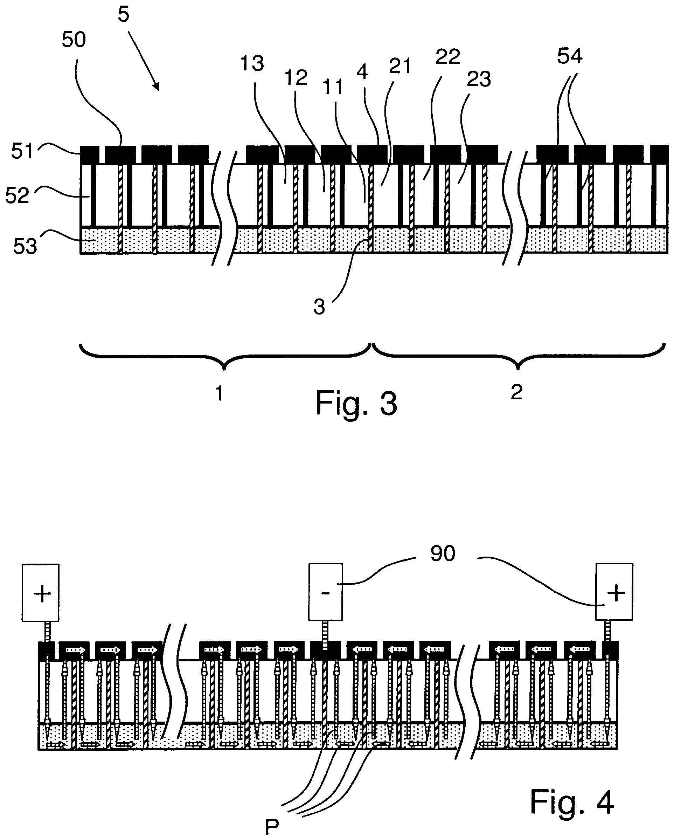

Die Fig. 3 zeigt ein monolithisch gefertigtes Dünnschichtsolarmodul 5 mit einer Rückseitenkontaktschicht 51, einer hierunter angeordneten Halbleiterschicht 52 und einer hierunter angeordneten Vorderseitenkontaktschicht 53. Ein Substrat, auf dem diese Schichtfolge 51, 52, 53 angeordnet ist, ist in der Fig. 3 und in den nachfolgenden Figuren nicht dargestellt, befindet sich jedoch vorzugsweise als Untergrund auf einer der Halbleiterschicht 52 abgewandten Seite der Vorderseitenkontaktschicht 53. Das Substrat ist aus Fensterglas gebildet, während die darauf angeordnete Vorderseitenkontaktschicht 53 aus einem transparenten leitfähigen Material, beispielsweise einem transparenten leitfähigen Oxid (TCO - transparent conductive oxide), gebildet und somit ebenfalls lichtdurchlässig ist. Die Rückseitenkontaktschicht 51 bildet eine Solarmoduloberfläche 50 aus, auf der mittels Sammelleitern, sogenannten Busbars, der in der Halbleiterschicht 52 erzeugte elektrische Strom abgegriffen wird.

Aufgrund einer Strukturierung der genannten Schichten 51, 52, 53, sind ein erstes Teilmodul 1 umfassend mehrere erste miteinander serienverschaltete Solarzellen 11, 12, 13 und ein zweites Teilmodul 2 umfassend mehrere zweite miteinander serienverschaltete Solarzellen 21, 22, 23 gebildet. Vorteilhafterweise sind noch weitere Teilmodule vorhanden, in welchem Fall es sich bei der Fig. 3 nur um eine Teilansicht des Dünnschichtsolarmoduls 5 handelt. Die einzelnen, sich in eine Erstreckungsrichtung senkrecht zur Ansichtsfläche der Fig. 3 streifenförmig erstreckenden Solarzellen 11, 12, ... sind mittels Isoliergräben voneinander getrennt. Die Isoliergräben erstrecken sich durch die Halbleiterschicht 52 und die Vorderseitenkontaktschicht 53 hindurch bis auf zum Substrat.

Demgegenüber erstrecken sich Kontaktgräben 54 lediglich durch die Halbleiterschicht 52 und verbinden die Vorderseitenkontaktschicht 53 mit der Rückseitenkontaktschicht 51, um die serielle Verschaltung der Solarzellen 11, 12, ... untereinander zu bilden. Die Kontaktgräben 54 sind zudem mit elektrisch leitendem Material gefüllt sind, beispielsweise mit dem Material der Rückseitenkontaktschicht 51, das beim Aufbringen dieser Rückseitenkontaktschicht 51 auch in die Kontaktgräben 54 dringt. Um ein derartiges Eindringen des leitfähigen Materials auch in die Isoliergräben 3 zu verhindern, werden Letztere vorteilhafterweise vollständig mit einem Isoliermaterial gefüllt.

Die beiden Teilmodule 1, 2 in der Fig. 3 sind zueinander benachbart angeordnet und mittels eines Gemeinschaftskontakts 4 miteinander verbunden, wobei der Gemeinschaftskontakt 4 einen gemeinsamen Rückseitenkontakt einer ersten Verbindungszelle 11 des ersten Teilmoduls 1 und einer zweiten Verbindungszelle 21 des zweiten Teilmoduls 2 bildet. Der Gemeinschaftskontakt 4 ist zudem Teil der Rückseitenkontaktschicht 51 und bei Strukturierung des Letzteren entstanden. In der in den Fig. 3 und 4 dargestellten Ausführungsform sind die Solarzellen 11, 12, ... der Teilmodule 1, 2 um den unterhalb des Gemeinschaftskontakts 4 angeordneten Isoliergraben 3 spiegelsymmetrisch gebildet.

In der Fig. 4 ist die gleiche Querschnittansicht wie in der Fig. 3 dargestellt, wobei hierauf überlagert Stromflusspfeile P dargestellt sind, welche den Stromfluss innerhalb des Dünnschichtsolarmodul 5 bei Betrieb veranschaulichen. Aufgrund der Dotierung der Halbleiterschicht 52 ist hierbei im vorliegend dargestellten Fall der Gemeinschaftskontakt 4 negativ polarisiert. Dies ist anhand schematisch eingezeichneter Abgreifkontakte 90 veranschaulicht, welche abhängig von der Stromflussrichtung in dem Dünnschichtsolarmodul 5 polarisiert sind.

Dass die beiden Verbindungszellen 11, 21 photovoltaisch aktiv sind, ist bereits daran erkennbar, dass der Stromverlauf zwischen dem Gemeinschaftskontakt 4 und der Vorderseitenkontaktschicht 53 durch diese Verbindungszellen 11, 21 verläuft und nicht wie bei der inaktiven Solarzelle 10' aus der Fig. 2 über Kontaktgräben, welche die inaktive Solarzelle 10' flankieren. Wie in der Fig. 4 anhand des Stromverlaufs erkennbar, sind die Teilmodule 1, 2 entgegengesetzt zueinander polarisiert. Dies folgt aus der spiegelbildlichen Ausgestaltung des Dünnschichtsolarmoduls 5 bezüglich einer Spiegelfläche, welche durch den die beiden Teilmodule 1, 2 beabstandende Isoliergraben verläuft. Die streng spiegelbildliche Ausgestaltung kann vorteilhaft sein, ist jedoch nicht notwendig, um eine entgegengesetzte Polarisierung der beiden Teilmodule 1, 2 zu erreichen.

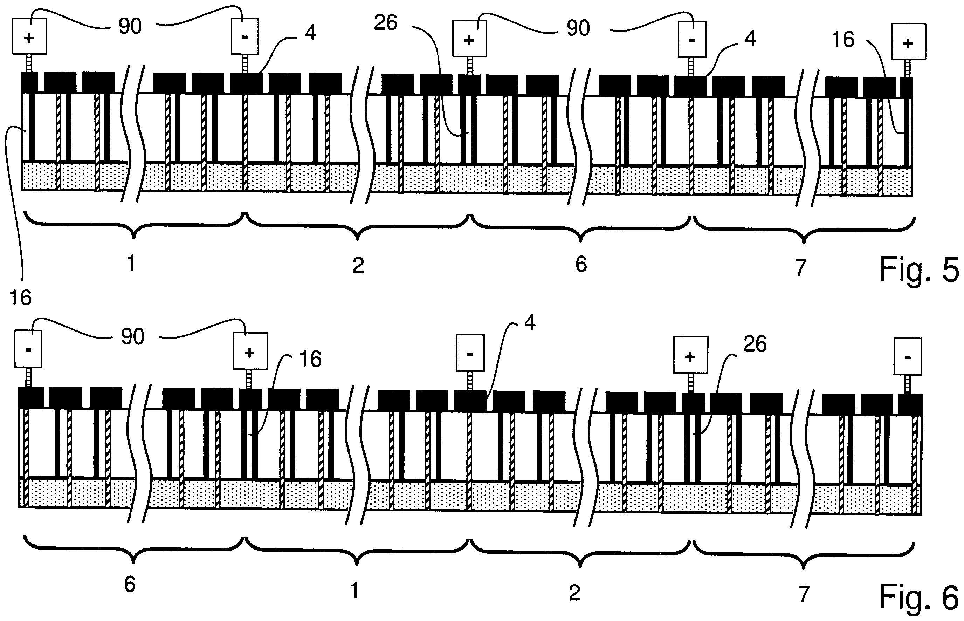

Fig. 5 und 6 zeigen jeweils ein Dünnschichtsolarmodul 5 mit zwei weiteren Teilmodulen 6, 7 zusätzlich zu dem ersten und dem zweiten Teilmodul 1, 2. Auch die weiteren Teilmodule 6, 7 sind aus serienverschalteten Solarzellen gebildet. Die Teilmodule 1, 2, 6, 7 sind miteinander parallel verschaltet, wobei die hierzu notwendigen Sammelleiter der Einfachheit halber in den Fig. 5 und 6 nicht eingezeichnet sind, sondern erst in den nachfolgenden Figuren erläutert werden.

In der Fig. 5 ist eines der weiteren Teilmodule 6 über eine photovoltaisch inaktive Brückensolarzelle 26 mit dem zweiten Teilmodul 2 verbunden. Die photovoltaisch inaktive Brückensolarzelle 26 kann hierbei wie die photovoltaisch inaktive Solarzelle 10' aus dem Stand der Technik aufgebaut sein, die vorangehend in der Beschreibungseinleitung erläutert wurde. Da die beiden weiteren Teilmodule 6, 7 wiederum über weitere Verbindungszellen mittels eines Gemeinschaftskontakts 4 verbunden sind, weist das Dünnschichtsolarmodul 5 gemäß Fig. 5 zwei photovoltaisch aktive Kontaktbereiche auf, nämlich jene, die mit den hier dargestellten negativen Abgreifkontakten 90 verbunden sind. Da es sich jedoch auch bei den äußersten beiden Solarzellen im hier dargestellten Dünnschichtsolarmodul 5 um weitere inaktive Brückensolarzellen 16 handelt, sind in dieser Ausführungsform insgesamt 3 inaktive Kontaktbereiche vorhanden, nämlich jene, die mit den hier dargestellten positiven Abgreifkontakten 90 verbunden sind.

Demgegenüber sind die Teilmodule 1, 2, 6, 7 in dem Dünnschichtsolarmodul 5 gemäß der in Fig. 6 dargestellten Ausführungsform anders verschaltet. Hier befinden sich die photovoltaisch inaktiven Brückensolarzellen 16, 26 jeweils zwischen dem ersten Teilmodul 1 und einem weiteren Teilmodul 6 und zwischen dem zweiten Teilmodul 2 und einem weiteren Teilmodul 7. Aufgrund dieser alternativen Verschaltung, weist das Dünnschichtsolarmodul 5 drei aktive und nur zwei inaktive Kontaktbereiche auf. Somit ist die Ausführungsform gemäß Fig. 6 ein gegenüber der Ausführungsform gemäß Fig. 5 optimiertes Dünnschichtsolarmodul 5 mit vier Teilmodulen.

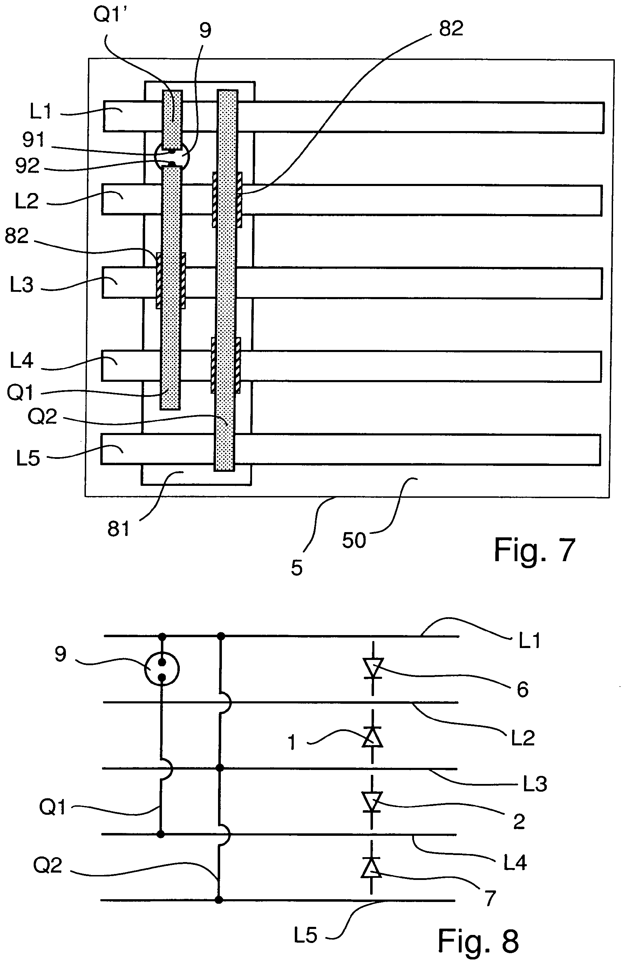

In Fig. 7 ist schematisch eine Draufsicht auf ein Dünnschichtsolarmodul 5 dargestellt, welches mittels Längssammelleitern L1, ..., L5 und Quersammelleitern Q1, Q2 verschaltetet ist. Hierzu ist zunächst ein Isolierband 81 auf der Solarmoduloberfläche 50 angeordnet, um einen unerwünschten Kurzschluss der Solarzellen aufgrund der Quersammelleiter Q1, Q2 zu verhindern. Anschließend wurden die Längssammelleiter L1, ..., L5 derart auf die Solarmoduloberfläche 50 aufgebracht, dass sie auf den Gemeinschaftskontakten 4 und / oder auf den Kontakten der inaktiven Brückensolarzellen 16, 26 aufliegen. Nicht auf dem Isolierband 81 aufliegende Abschnitte der Längssammelleiter L1, ..., L5 kontaktieren vorzugsweise vollflächig oder zumindest Abschnittsweise die darunterliegenden Kontakte der Solarzellen 11, 12, ...

Die Längssammelleiter L1, ..., L5 sind mittels der Quersammelleiter Q1, Q2 derartig elektrisch verbunden, dass die Teilmodule 1, 2, 5, 6 (in der Fig. 7 nicht explizit dargestellt) eine Parallelverschaltung bilden. Ferner sind die Teilmodule 1, 2, 6, 7 über die Quersammelleiter Q1, Q2 mit Polen 91, 92 eines Modulaußenanschlusses 9 zum Abgreifen der im Dünnschichtsolarmodul 5 erzeugten elektrischen Energie verbunden. Während eines der Quersammelleiter Q2 mit drei Längssammelleitern L1, L3, L5 verbunden ist, verhindern Isolierstreifen 82 an Kreuzungspunkten zwischen diesem Quersammelleiter Q2 und zwei weiteren Längssammelleitern L2, L4 einen elektrischen Kontakt mit diesen.

Diese beiden weiteren Längssammelleiter L2, L4 sind stattdessen mit dem anderen Quersammelleiter Q1 verbunden, welcher an einem Pol 92 des Modulaußenanschlusses 9 angeschlossen ist. Einer der Längssammelleiter L1 ist wiederum über einen Sammelleiterabschnitt Q1' mit dem anderen Pol 91 des Modulaußenanschlusses 9 verbunden. Bei dem Sammelleiterabschnitt Q1' handelt es sich vorzugsweise um einen Abschnitt des Quersammelleiters Q1, welcher nach dem Anordnen auf und Verbinden mit den Längssammelleitern L1, L2, L4 in einem Bereich zwischen den Polen 91, 92 des Modulaußenanschlusses 9 durchtrennt wird.

Die Verschaltung des Dünnschichtsolarmoduls 5 gemäß der Fig. 7 wird in der Fig. 8 anhand eines Schaltplans erläutert. Bei dem Schaltplan handelt es sich um ein Ersatzschaltbild für das Dünnschichtsolarmodul 5, bei dem die Teilmodule 1, 2, 6, 7 in Form von Dioden dargestellt sind, welche über Längssammelleiter L1, ..., L5 und Quersammelleiter Q1, Q2 miteinander und mit dem Modulaußenanschluss 9 verbunden sind. Hierbei ist deutlich erkennbar, dass die Teilmodule 1, 2, 6, 7 entlang der Querrichtung alternierend polarisiert sind.

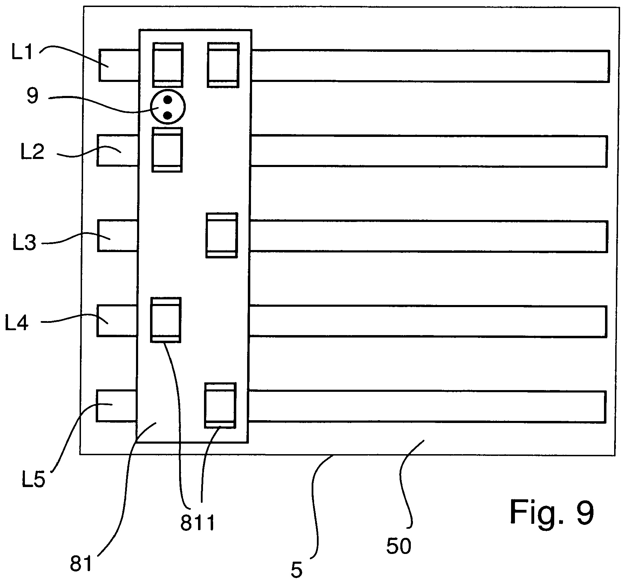

Schließlich veranschaulicht die Fig. 9 eine alternative Möglichkeit, die gleiche Verschaltung der Teilmodule 1, 2, 6, 7 wie anhand der Fig. 7 und 8 beschrieben, mittels eines speziell vorbereiteten Isolierbandes 81, ohne die Verwendung zusätzlicher Isolierstreifen 82, zu erreichen. Fig. 9 zeigt hierbei die Längssammelleiter L1, ..., L5, welche direkt auf die Solarmoduloberfläche 50 aufgebracht sind, und zwar wie in der Fig. 7, jedoch ohne vorheriges Aufbringen des Isolierbandes 81. Anschließend wird ein Isolierband 81 über die Längssammelleiter L1, ..., L5 gelegt, das an vorgesehenen Kontaktpunkten zwischen den Längssammelleitern L1, ..., L5 und den Quersammelleitern Q1, Q2 Öffnungen 811 aufweist. Alternativ können die Öffnungen 811 auch erst nach dem Aufbringen des Isolierbandes 81 gebildet werden.

Die Quersammelleiter Q1, Q2, welche anschließend auf dem Isolierband 81 angeordnet und durch die Öffnungen 811 hindurch mit den Längssammelleitern L1, ..., L5 kontaktiert werden, sind in der Fig. 9 zur besseren Übersicht nicht eingezeichnet. Wie in der Ausführungsform gemäß Fig. 7, kann auch in der Ausführungsform gemäß Fig. 9 das Isolierband 81 aus zwei oder mehr Abschnitten bestehen, welche jeweils nur unterhalb eines der Quersammelleiter Q1, Q2 angeordnet sind.

### Bezugszeichenliste

- 1', 2': Teilmodule
- 10': photovoltaisch inaktive Solarzelle

- 1: erstes Teilmodul
- 11, 12, 13, ...: erste Solarzellen
- 11: erste Verbindungszelle
- 2: zweites Teilmodul
- 21, 22, 23, ...: zweite Solarzellen
- 21: zweite Verbindungszelle
- 3: Isoliergraben
- 4: Gemeinschaftskontakt
- 5: Dünnschichtsolarmodul
- 50: Solarmoduloberfläche
- 51: Rückseitenkontaktschicht
- 52: Halbleiterschicht
- 53: Vorderseitenkontaktschicht
- 54: Kontaktgräben
- 6, 7: weitere Teilmodule
- 16, 26: inaktive Brückensolarzellen
- 81: Isolierband
- 811: Öffnungen
- 82: Isolierstreifen
- 9: Modulaußenanschluss
- 91, 92: Pole des Modulaußenanschlusses
- 90: Abgreifkontakte
- L1, L2, L3, L4, L5: Längssammelleiter
- Q1, Q2: Quersammelleiter
- Q1': Sammelleiterabschnitt
- P: Stromflusspfeile

## Patentansprüche

1. Dünnschichtsolarmodul (5) umfassend zumindest ein erstes Teilmodul (1) mit mehreren untereinander serienverschalteten ersten Dünnschicht-Solarzellen (11, 12, 13, ...) und ein mit dem ersten Teilmodul (1) parallelverschaltetes zweites Teilmodul (2) mit mehreren untereinander serienverschalteten zweiten Dünnschicht-Solarzellen (21, 22, 23, ...), wobei die Teilmodule (1, 2) auf einem gemeinsamen Substrat monolithisch gebildet sind und wobei die Dünnschicht-Solarzellen (11, 12, 13, ..., 21, 22, 23, ...) streifenförmig ausgebildet sind; **dadurch gekennzeichnet, dass** eine erste Verbindungszelle (11) aus den ersten Dünnschicht-Solarzellen (11, 12, 13, ...) und eine zweite Verbindungszelle (21) aus den zweiten Dünnschicht-Solarzellen (21, 22, 23, ...) benachbart zueinander angeordnet, mittels eines Isoliergrabens (3) voneinander beabstandet und über einen Gemeinschaftskontakt (4) miteinander elektrisch verbunden sind, wobei sich der Isoliergraben (3) im Wesentlichen entlang einer gesamten Länge der angrenzenden Verbindungszellen (11, 21) parallel zu der streifenförmigen Ausbildung erstreckt, und wobei der Isoliergraben (3) entlang einer Spiegelfläche verläuft, bezüglich derer das erste Teilmodul (1) und das zweite Teilmodul (2) zueinander im Wesentlichen spiegelbildlich ausgebildet sind, wobei die Solarzellenstreifen eines Teilmodules (1, 2) aneinander in einer ersten Richtung anliegen und der Isoliergraben (3) parallel zu dieser ersten Richtung liegt.

2. Dünnschichtsolarmodul (5) nach Anspruch 1, **dadurch gekennzeichnet, dass** der Gemeinschaftskontakt (4) monolithisch aufgebracht und Teil einer Rück- oder Vorderseitenkontaktschicht ist.

3. Dünnschichtsolarmodul (5) nach Anspruch 1 oder 2, **dadurch gekennzeichnet, dass** eine entgegengesetzte Polarisation der Teilmodule (1, 2) besteht, sodass die erzeugten Ströme in Bezug auf die Spiegelfläche in Gegenrichtung zueinander fließen.

4. Dünnschichtsolarmodul (5) nach einem der Ansprüche 1 bis 3, **dadurch gekennzeichnet, dass** Gemeinschaftskontakt (4) und Isoliergraben (3) entlang der Spiegelfläche verlaufen und der Isoliergraben (3) unterhalb des Gemeinschaftskontaktes (4) ausgebildet ist.

5. Dünnschichtsolarmodul (5) nach einem der Ansprüche 1 bis 4, **dadurch gekennzeichnet, dass** sich der Isoliergraben (3) zumindest im Wesentlichen vollständig über eine Halbleiterschichtdicke einer Halbleiterschicht (52) und über eine Kontaktschichtdicke einer Vorderseitenkontaktschicht (53) erstreckt und/oder dassder Isoliergraben (3) teilweise oder vollständig mit einem Isoliermaterial gefüllt ist.

6. Dünnschichtsolarmodul (5) nach einem der vorangehenden Ansprüche, **dadurch gekennzeichnet, dass** die erste Verbindungszelle (11) und / oder die zweite Verbindungszelle (21) photovoltaisch aktiv ist.

7. Dünnschichtsolarmodul (5) nach einem der vorherigen Ansprüche, **gekennzeichnet durch** weitere auf dem Substrat gebildete Teilmodule (6, 7), wobei die Teilmodule (1, 2, 6, 7) in ihrer Abfolge alternierend polarisiert sind, wobei bevorzugt vorgesehen ist, **dass** zumindest zwei Teilmodule (2, 6) über eine photovoltaisch inaktive Brückensolarzelle (16, 26) miteinander parallel verschaltet sind.

8. Dünnschichtsolarmodul (5) nach einem der vorherigen Ansprüche, **gekennzeichnet durch** sich entlang einer Erstreckungsrichtung der streifenförmigen Solarzellen (11, 12, 13, ..., 21, 22, 23, ...) erstreckende Längssammelleiter (L1, L2, L3, L4, L5), von denen einer auf dem Gemeinschaftskontakt (4) angeordnet und mit diesem elektrisch verbunden ist, und durch zwei quer zu den Längssammelleitern (L1, L2, L3, L4, L5) verlaufende und diese kontaktierende Quersammelleiter (Q1, Q2), wobei bevorzugt vorgesehen ist, **dass** zwischen den Längssammelleitern (L1, L2, L3, L4, L5) und den Quersammelleiter (Q1, Q2) Isolierstreifen (82) derart angeordnet sind, dass mittels der Längssammelleiter (L1, L2, L3, L4, L5) und der Quersammelleiter (Q1, Q2) die Parallelverschaltung der Teilmodule (1, 2, 6, 7) hergestellt ist.

9. Dünnschichtsolarmodul (5) nach Anspruch 8, **dadurch gekennzeichnet, dass** zwischen den Quersammelleitern (Q1, Q2) und einer Rückseitenkontaktschicht (51) des Dünnschichtsolarmoduls (5) zumindest ein Isolierband (81) angeordnet ist.

10. Dünnschichtsolarmodul (5) nach einem der vorangehenden Ansprüche 8 oder 9 mit Merkmalen des Anspruchs 7, **dadurch gekennzeichnet dass** die Längssammelleiter (L1, L2, L3, L4, L5) entlang der Querrichtung alternierend auf einem Gemeinschaftskontakt (4) und auf einem Kontakt einer Brückensolarzelle (16, 26) angeordnet und damit elektrisch verbunden sind.

11. Herstellungsverfahren eines Dünnschichtsolarmoduls (5) umfassend den Verfahrensschritt:
- Erzeugen einer Dünnschichtsolarzellenstruktur mit einer Solarmoduloberfläche (50) und zumindest zwei auf einem gemeinsamen Substrat monolithisch angeordneten, miteinander parallelverschalteten Teilmodulen (1, 2), welche jeweils aus mehreren miteinander serienverschalteten, streifenförmigen Dünnschicht-Solarzellen (11, 12, ..., 21, 22 ...) gebildet sind; **dadurch gekennzeichnet, dass** eine erste Verbindungszelle (11) aus den ersten Dünnschicht-Solarzellen (11, 12, 13, ...) und eine zweite Verbindungszelle (21) aus den zweiten Dünnschicht-Solarzellen (21, 22, 23, ...) benachbart zueinander angeordnet, mittels eines Isoliergrabens (3) voneinander beabstandet und über einen Gemeinschaftskontakt (4) miteinander elektrisch verbunden werden, wobei die Dünnschicht-Solarzellen (11, 12, 13, ..., 21, 22, 23, ...) streifenförmig ausgebildet sind, weiterhin **gekennzeichnet durch**
- den sich im Wesentlichen entlang einer gesamten Länge der angrenzenden Verbindungszellen (11, 21) parallel zu der streifenförmigen Ausbildung erstreckenden Isoliergraben (3), wobei der Isoliergraben (3) entlang einer Spiegelfläche verläuft, bezüglich derer das erste Teilmodul (1) und das zweite Teilmodul (2) zueinander im Wesentlichen spiegelbildlich ausgebildet sind, wobei die Solarzellenstreifen eines Teilmodules (1, 2) aneinander in einer ersten Richtung anliegen und der Isoliergraben (3) parallel zu dieser ersten Richtung liegt, und die folgende Verfahrensschritte:
- Aufbringen eines Isolierbandes (81) auf die Solarmoduloberfläche (50);
- Aufbringen mehrerer Längssammelleiter (L1, L2, L3, L4, L5) auf die Solarmoduloberfläche (50); und
- Aufbringen zumindest zweier Quersammelleiter (Q1, Q2) auf die Solarmoduloberfläche (50) quer zu einer Erstreckungsrichtung der Längssammelleiter (L1, L2, L3, L4, L5),
wobei das Aufbringen des Isolierbandes (81), der Längssammelleiter (L1, L2, L3, L4, L5) und der Quersammelleiter (Q1, Q2) derart erfolgt, dass mittels der Längssammelleiter (L1, L2, L3, L4, L5) und der Quersammelleiter (Q1, Q2) die Parallelverschaltung der Teilmodule (1, 2, 6, 7) hergestellt wird.

12. Herstellungsverfahren nach Anspruch 11, **dadurch gekennzeichnet, dass** das Isolierband (81) nach dem Aufbringen der Längssammelleiter (L1, L2, L3, L4, L5) und vor dem Aufbringen der Quersammelleiter (Q1, Q2) auf die Solarmoduloberfläche (50) aufgebracht wird, wobei vor, während oder nach dem Aufbringen des Isolierbandes (81) Öffnungen (811) in das Isolierband (81) zur Kontaktierung der Längssammelleiter (L1, L2, L3, L4, L5) mit den Quersammelleiter (Q1, Q2) erzeugt werden.

13. Herstellungsverfahren nach Anspruch 11, **dadurch gekennzeichnet, dass** die Längssammelleiter (L1, L2, L3, L4, L5) auf das Isolierband (81) aufgebracht werden, wobei nach dem Aufbringen der Längssammelleiter (L1, L2, L3, L4, L5) und vor dem Aufbringen der Quersammelleiter (Q1, Q2) Isolierstreifen (82) an Kreuzungspunkten zwischen den Längssammelleitern (L1, L2, L3, L4, L5) und den Quersammelleitern (Q1, Q2) angeordnet werden.

14. Herstellungsverfahren nach Anspruch 11, **dadurch gekennzeichnet, dass** die Längssammelleiter (L1, L2, L3, L4, L5) auf das Isolierband (81) aufgebracht werden, wobei vor dem Aufbringen der Längssammelleiter (L1, L2, L3, L4, L5) und nach dem Aufbringen der Quersammelleiter (Q1, Q2) Isolierstreifen (82) an Kreuzungspunkten zwischen den Längssammelleitern (L1, L2, L3, L4, L5) und den Quersammelleitern (Q1, Q2) angeordnet werden.

15. Herstellungsverfahren nach einem der Ansprüche 11 bis 14, **dadurch gekennzeichnet, dass** eines der Quersammelleiter (Q1) mit beiden Polen (91, 92) eines Modulaußenanschlusses (9) elektrisch verbunden wird, wobei der Quersammelleiter (Q1) vor oder nach dem Verbinden mit den Polen (91, 92) des Modulaußenanschlusses (9) durchtrennt wird, um die beiden Pole (91, 92) voneinander elektrisch zu isolieren.

## Claims

1. Thin film solar module (5), comprising:
at least one first sub module (1) including a plurality of first thin film solar cells (11, 12, 13, ...) connected with one another in series; and
at least one second sub module (2) connected with the at least one first sub module (1) in parallel, the at least one second sub module (2) including a plurality of second thin film solar cells (21, 22, 23, ...) connected with one another in series,
wherein the sub modules (1, 2) are formed on a shared substrate in a monolithic manner, and wherein the thin film solar cells (11, 12, 13, ..., 21, 22, 23, ...) are configured strip shaped,
**characterized in that**
a first connecting cell (11) included in the plurality of the first thin film solar cells (11, 12, 13, ...) and a second connecting cell (21) included in the plurality of the second thin film solar cells (21, 22, 23, ...) are arranged adjacent to one another, spaced apart from each other through an insulation trench (3) and electrically connected with one another through a shared contact (4),
wherein the insulation trench (3) extends essentially parallel to the strip shaped formation over a total length of the adjoining connecting cells (11, 21),
wherein the insulation trench (3) extends along a mirror plane with respect to which the at least one first sub module (1) and the at least one second sub module (2) are respectively configured essentially as mirror images of one another,
wherein the solar cell strips of a sub module (1, 2) abut against each other in a first direction and the insulation trench (3) is arranged parallel with respect to the first direction.

2. Thin film solar module (5) according to claim 1, **characterized in that** the shared contact (4) is formed in a monolithic manner and is part of a back side contact layer or a front side contact layer.

3. Thin film solar module (5) according to claim 1 or 2, **characterized in that** an opposite polarization exits for the sub modules (1, 2), so that the currents generated flow in opposite directions to one another with respect to the mirror plane.

4. Thin film solar module (5) according to one of claims 1 through 3, **characterized in that** shared contact (4) and insulation trench (3) extend alongside the mirror plane and the insulation trench (3) is formed below the shared contact (4).

5. Thin film solar module (5) according to one of claims 1 through 4, **characterized in that** the insulation trench (3) extends essentially at least completely over a semiconductor layer thickness of a semiconductor layer (52) and over a contact layer thickness of a front side contact layer (53) and/or **in that** the insulation trench (3) is partially or completely filled with an insulation material.

6. Thin film solar module (5) according to one of the preceding claims, **characterized in that** the first connecting cell (11) and/or the second connecting cell (21) are photovoltaically active.

7. Thin film solar module (5) according to one of the preceding claims, **characterized through** additional sub modules (6, 7) formed on the substrate, wherein the sub modules (1, 2, 6, 7) are polarized in an alternating sequence, wherein preferably at least two sub modules (2, 6) are connected with one another in parallel through a photovoltaically inactive bridge solar cell (26).

8. Thin film solar module (5) according to one of the preceding claims, **characterized through** longitudinal collection conductors (L1, L2, L3, L4, L5) extending along an extension direction of the stripe shaped thin film solar cells (11, 12, 13, ..., 21, 22, 23, ...),
wherein one of the longitudinal collection conductors is arranged on the shared contact (4) and electrically connected therewith, and **through** two transversal collection conductors (Q1, Q2) extending transversal to the longitudinal collection conductors (L1, L2, L3, L4, L5) and contacting the longitudinal collection conductors (L1, L2, L3, L4, L5), wherein it is preferably provided that insulation strips (82) are arranged between the longitudinal collection conductors (L1, L2, L3, L4, L5) and the transversal collection conductors (Q1, Q2), so that parallel connection of the sub modules (1, 2, 6, 7) is provided through the longitudinal collection conductors (L1, L2, L3, L4, L5) and the transversal collection conductors (Q1, Q2).

9. Thin film solar module (5) according to claim 8, **characterized in that** at least one insulation tape (81) is arranged between the transversal collection conductors (Q1, Q2) and a backside contact layer (51) of the thin film solar module (5).

10. Thin film solar module (5) according to one of claims 8 or 9 in connection with the features of claim 7, **characterized in that** the longitudinal collection conductors (L1, L2, L3, L4, L5) are arranged in transversal direction in an alternating manner on the shared contact (4) and on a contact of a photovoltaically inactive bridge solar cell (16, 26) and are electrically connected therewith.

11. Production method for producing a thin film solar module (5), comprising the step:
producing a thin film solar cell structure with a solar module surface (50) and at least two sub modules (1, 2) that are monolithically arranged on a shared substrate and connected with one another in parallel, wherein wherein the at least two sub modules (1, 2) are respectively formed from plural thin film solar cells (11, 12, 13, ..., 21, 22, 23, ...) connected with one another in series and configured strip shaped,
**characterized in that**
a first connecting cell (11) included in the first thin film solar cells (11, 12, 13, ...) and a second connecting cell (21) included in the second thin film solar cells (21, 22, 23, ...) are arranged adjacent to one another, spaced apart from one another through an insulation trench (3) and electrically connected with one another through a shared contact (4),
wherein the thin film solar cells (11, 12, 13, ..., 21, 22, 23, ...) are configured strip shaped,
**further characterized through**
the insulation trench (3) extending essentially parallel to the strip shaped formation over a total length of the adjoining connecting cells (11, 21),
wherein the insulation trench (3) extend along a mirror plane with reference to which mirror plane the first sub module (1) and the second sub module (2) are respectively configured essentially as mirror images of one another,
wherein the solar cell strips of a sub module (1, 2) abut against each other in a first direction and the insulation trench (3) is arranged parallel with respect to the first direction,
and the further steps:
applying an insulation tape (81) to the solar module surface (50);
applying plural longitudinal collection conductors (L1, L2, L3, L4, L5) to the solar module surface (50); and
applying at least two transversal collection conductors (Q1, Q2) to the solar module surface (50) transversal to an extension direction of the longitudinal collection conductors (L1, L2, L3, L4, L5),
wherein the insulation tape (81), the longitudinal collection conductors (L1, L2, L3, L4, L5) and the transversal collection conductors (Q1, Q2) are applied so that the parallel connection of the sub modules (1, 2, 6, 7) is provided through the longitudinal collection conductors (L1, L2, L3, L4, L5) and the transversal collection conductors (Q1, Q2).

12. Production method according to claim 11, **characterized in that** the insulation tape (81) is applied to the solar module surface (50) after applying the longitudinal collection conductors (L1, L2, L3, L4, L5) and before applying the transversal collection conductors (Q1, Q2), and wherein openings (811) in the insulation tape (81) for contacting the longitudinal collection conductors (L1, L2, L3, L4, L5) with the transversal collection conductors (Q1, Q2) are produced before, during or after applying the insulation tape (81).

13. Production method according to claim 11, **characterized in that** the longitudinal collection conductors (L1, L2, L3, L4, L5) are applied to the insulation tape (81), and wherein insulation strips (82) are arranged at intersection points between the longitudinal collection conductors (L1, L2, L3, L4, L5) and the transversal collection conductors (Q1, Q2) after applying the longitudinal collection conductors (L1, L2, L3, L4, L5) and before applying the transversal collection conductors (Q1, Q2).

14. Production method according to claim 11, **characterized in that** the longitudinal collection conductors (L1, L2, L3, L4, L5) are applied to the insulation tape (81), and wherein insulation strips (82) are arranged at intersection points between the longitudinal collection conductors (L1, L2, L3, L4, L5) and the transversal collection conductors (Q1, Q2) before applying the longitudinal collection conductors (L1, L2, L3, L4, L5) and after applying the transversal collection conductors (Q1, Q2).

15. Production method according to one of claims 11 through 14, **characterized in that** one of the transversal collection conductors (1) is electrically connected with both poles (91, 92) of an external module connection (9), and wherein the transversal collection conductor (Q1) is cut before or after connection with the poles (91, 92) of the external module connection (9) in order to electrically insulate the two poles (91, 92) from one another.

## Revendications

1. Module solaire à couche mince (5) comprenant au moins un premier module partiel (1) pourvu de plusieurs premières cellules solaires à couche mince (11, 12, 13, ...) branchées en séries entre elles et un deuxième module partiel (2), branché en parallèle avec le premier module partiel (1) et pourvu de plusieurs deuxièmes cellules solaires à couche mince (21, 22, 23, ...) branchées en séries entre elles, les modules partiels (1, 2) étant formés de manière monolithique sur un substrat commun et les cellules solaires à couche mince (11, 12, 13, ..., 21, 22, 23, ...) étant réalisées en forme de bandes, **caractérisé en ce que** une première cellule de liaison (11) parmi les premières cellules solaires à couche mince (11, 12, 13, ...) et une deuxième cellule de liaison (21) parmi les deuxièmes cellules solaires à couche mince (21, 22, 23, ...) sont disposées voisines l'une de l'autre, espacées l'une de l'autre au moyen d'une tranchée isolante (3) et reliées électriquement l'une à l'autre par le biais d'un contact commun (4), la tranchée isolante (3) s'étendant sensiblement sur une longueur totale des cellules de liaison (11, 21) adjacentes parallèlement à la configuration en forme de bande, et
la tranchée isolante (3) s'étendant le long d'une surface de miroir en référence à laquelle le premier module partiel (1) et le deuxième module partiel (2) sont configurés sensiblement inversés géométriquement l'un par rapport à l'autre, les bandes de cellules solaires d'un module partiel (1, 2) reposant les unes contre les autres dans une première direction et la tranchée isolante (3) étant parallèle à cette première direction.

2. Module solaire à couche mince (5) selon la revendication 1, **caractérisé en ce que** le contact commun (4) est appliqué de manière monolithique et est une partie d'une couche de contact de côté avant ou de côté arrière.

3. Module solaire à couche mince (5) selon la revendication 1 ou 2, **caractérisé en ce qu'**il existe une polarisation inverse des modules partiels (1, 2), de sorte que les courants générés circulent en sens inverse l'un par rapport à l'autre par rapport à la surface de miroir.

4. Module solaire à couche mince (5) selon l'une des revendications 1 à 3, **caractérisé en ce que** le contact commun (4) et la tranchée isolante (3) s'étendent le long de la surface de miroir et la tranchée isolante (3) est formée au-dessous du contact commun (4).

5. Module solaire à couche mince (5) selon l'une des revendications 1 à 4, **caractérisé en ce que** la tranchée isolante (3) s'étend au moins sensiblement entièrement sur une épaisseur de couche semiconductrice d'une couche semiconductrice (52) et sur une épaisseur de couche de contact d'une couche de contact de côté avant (53) et/ou **en ce que** la tranchée isolante (3) est partiellement ou entièrement remplie d'un matériau isolant.

6. Module solaire à couche mince (5) selon l'une des revendications précédentes, **caractérisé en ce que** la première cellule de liaison (11) et/ou la deuxième cellule de liaison (21) sont actives du point de vue photovoltaïque.

7. Module solaire à couche mince (5) selon l'une des revendications précédentes, **caractérisé par** des modules partiels (6, 7) supplémentaires formés sur le substrat, les modules partiels (1, 2, 6, 7) étant polarisés séquentiellement en alternance, en prévoyant de préférence qu'au moins deux modules partiels (2, 6) sont branchés en parallèle l'un avec l'autre par le biais d'une cellule solaire de pontage (16, 26) inactive du point de vue photovoltaïque.

8. Module solaire à couche mince (5) selon l'une des revendications précédentes, **caractérisé par** des conducteurs collecteurs longitudinaux (L1, L2, L3, L4, L5) qui s'étendent le long d'une direction d'extension des cellules solaires (11, 12, 13, ..., 21, 22, 23, ...) en forme de bandes, parmi lesquels l'un est disposé sur le contact commun (4) et est relié électriquement à celui-ci, et par deux conducteurs collecteurs transversaux (Q1, Q2) qui s'étendent transversalement par rapport aux conducteurs collecteurs longitudinaux (L1, L2, L3, L4, L5) et sont mis en contact avec ceux-ci, en prévoyant de préférence qu'entre les conducteurs collecteurs longitudinaux (L1, L2, L3, L4, L5) et les conducteurs collecteurs transversaux (Q1, Q2) sont disposées des rubans isolants (82) de telle sorte que le branchement en parallèle des modules partiels (1, 2, 6, 7) est établi au moyen des conducteurs collecteurs longitudinaux (L1, L2, L3, L4, L5) et des conducteurs collecteurs transversaux (Q1, Q2).

9. Module solaire à couche mince (5) selon la revendication 8, **caractérisé en ce qu'**au moins un ruban isolant (81) est disposé entre les conducteurs collecteurs transversaux (Q1, Q2) et une couche de contact de côté arrière (51) du module solaire à couche mince (5).

10. Module solaire à couche mince (5) selon l'une des revendications précédentes 8 ou 9 avec les caractéristiques de la revendication 7, **caractérisé en ce que** les conducteurs collecteurs longitudinaux (L1, L2, L3, L4, L5) sont disposés en alternance le long de la direction transversale sur un contact commun (4) et sur un contact d'une cellule solaire de pontage (16, 26) et sont ainsi reliés électriquement.

11. Procédé de fabrication d'un module solaire à couche mince (5), comprenant l'étape suivants :
- production d'une structure de cellules solaires à couche mince comportant une surface de module solaire (50) et au moins deux modules partiels (1, 2) disposés de manière monolithique sur un substrat commun et branchés en parallèle, lesquels sont respectivement formés de plusieurs cellules solaires à couche mince (11, 12, ..., 21, 22 ...) en forme de bandes branchées en séries entre elles, **caractérisé en ce que** une première cellule de liaison (11) parmi les premières cellules solaires à couche mince (11, 12, 13, ...) et une deuxième cellule de liaison (21) parmi les deuxièmes cellules solaires à couche mince (21, 22, 23, ...) sont disposées voisines l'une de l'autre, espacées l'une de l'autre au moyen d'une tranchée isolante (3) et reliées électriquement l'une à l'autre par le biais d'un contact commun (4), les cellules solaires à couche mince (11, 12, 13, ..., 21, 22, 23, ...) étant réalisées en forme de bandes,
**caractérisé en outre par**
- la tranchée isolante (3) qui s'étend sensiblement sur une longueur totale des cellules de liaison (11, 21) adjacentes parallèlement à la configuration en forme de bande, la tranchée isolante (3) s'étendant le long d'une surface de miroir en référence à laquelle le premier module partiel (1) et le deuxième module partiel (2) sont configurés sensiblement inversés géométriquement l'un par rapport à l'autre, les bandes de cellules solaires d'un module partiel (1, 2) reposant les unes contre les autres dans une première direction et la tranchée isolante (3) étant parallèle à cette première direction,
et les étapes suivantes :
- application d'un ruban isolant (81) sur la surface du module solaire (50) ;
- application de plusieurs conducteurs collecteurs longitudinaux (L1, L2, L3, L4, L5) sur la surface du module solaire (50) ; et
- application d'au moins deux des conducteurs collecteurs transversaux (Q1, Q2) sur la surface du module solaire (50) transversalement par rapport à une première direction d'extension des conducteurs collecteurs longitudinaux (L1, L2, L3, L4, L5), l'application du ruban isolant (81), des conducteurs collecteurs longitudinaux (L1, L2, L3, L4, L5) et des conducteurs collecteurs transversaux (Q1, Q2) s'effectuant de telle sorte que le branchement en parallèle des modules partiels (1, 2, 6, 7) est établi au moyen des conducteurs collecteurs longitudinaux (L1, L2, L3, L4, L5) et des conducteurs collecteurs transversaux (Q1, Q2).

12. Procédé de fabrication selon la revendication 11, **caractérisé en ce que** le ruban isolant (81) est appliqué sur la surface du module solaire (50) après l'application des conducteurs collecteurs longitudinaux (L1, L2, L3, L4, L5) et avant l'application des conducteurs collecteurs transversaux (Q1, Q2), des ouvertures (811) étant produites dans le ruban isolant (81) avant, pendant ou après l'application du ruban isolant (81) pour la mise en contact des conducteurs collecteurs longitudinaux (L1, L2, L3, L4, L5) avec les conducteurs collecteurs transversaux (Q1, Q2).

13. Procédé de fabrication selon la revendication 11, **caractérisé en ce que** les conducteurs collecteurs longitudinaux (L1, L2, L3, L4, L5) sont appliqués sur le ruban isolant (81), des bandes isolantes (82) étant disposées au niveau de points d'intersection entre les conducteurs collecteurs longitudinaux (L1, L2, L3, L4, L5) et les conducteurs collecteurs transversaux (Q1, Q2) après l'application des conducteurs collecteurs longitudinaux (L1, L2, L3, L4, L5) et avant l'application des conducteurs collecteurs transversaux (Q1, Q2).

14. Procédé de fabrication selon la revendication 11, **caractérisé en ce que** les conducteurs collecteurs longitudinaux (L1, L2, L3, L4, L5) sont appliqués sur le ruban isolant (81), des bandes isolantes (82) étant disposées au niveau de points d'intersection entre les conducteurs collecteurs longitudinaux (L1, L2, L3, L4, L5) et les conducteurs collecteurs transversaux (Q1, Q2) avant l'application des conducteurs collecteurs longitudinaux (L1, L2, L3, L4, L5) et après l'application des conducteurs collecteurs transversaux (Q1, Q2).

15. Procédé de fabrication selon l'une des revendications 11 à 14, **caractérisé en ce que** l'un des conducteurs collecteurs transversaux (Q1) est relié électriquement aux deux pôles (91, 92) d'une borne extérieure de module (9), le conducteur collecteur transversal (Q1) étant sectionné avant ou après la liaison avec les pôles (91, 92) de la borne extérieure de module (9) afin d'isoler électriquement les deux pôles (91, 92) l'un de l'autre.
